**Europäisches Patentamt**

**European Patent Office**

**Office européen des brevets**

(19)

(11) Veröffentlichungsnummer: **0 439 658 A1**

# (12) EUROPÄISCHE PATENTANMELDUNG

(21) Anmeldenummer: 90101939.8

(22) Anmeldetag: 31.01.90

(51) Int. Cl.⁵: **G01R 23/17, G02F 1/11**

(43) Veröffentlichungstag der Anmeldung:
**07.08.91 Patentblatt 91/32**

(84) Benannte Vertragsstaaten:
**FR GB IT**

(71) Anmelder: **Siemens Aktiengesellschaft**
**Wittelsbacherplatz 2**
**W-8000 München 2(DE)**

(72) Erfinder: **Zensen, Wilfried, Dr.**
**Wessobrunner Strasse 2**
**W-8035 Gauting(DE)**

(54) **Interferometrischer Braggzellen-Spektralanalysator.**

(57)
2.1. Bei interferometrischen Braggzellen-Spektralanalysatoren mit Referenz-Braggzelle erzeugt das von dieser Braggzelle erzeugte Referenzlicht einen Störuntergrund, der vermieden werden soll.
2.2. Dazu wird anstelle der herkömmlichen Referenz-Braggzelle eine Einrichtung (RE) zum voneinander getrennten Erzeugen von Referenzlichtstrahlen (R$_i$) und getrennten Überlagern der Referenzlichtstrahlen (R$_i$) mit von der Signal-Braggzelle (BZ) abgelenktem Licht (S) verwendet.
2.3. Anwendung zur Spektralanalyse von Hochfrequenzsignalen

FIG 1

EP 0 439 658 A1

## INTERFEROMETRISCHER BRAGGZELLEN-SPEKTRALANALYSATOR

Die Erfindung betrifft einen interferometrischen Braggzellen Spektralanalysator nach dem Oberbegriff des Patentanspruchs 1.

Analysatoren der genannten Art sind beispielsweise aus Appl. Optic, Vol. 20, No. 16, 15. Nov. 1981, S. 2270-2279, aus Appl. Optics, Vol. 23, No. 23, 1. Dez. 1984, S. 4269-4279 oder auch aus SPIE, Vol. 639, Optical Information Processing II (1986), S. 126-130 bekannt.

Bei diesen bekannten Analysatoren besteht die Einrichtung zum Erzeugen von mehreren gegeneinander frequenzverschobenen Referenzlichtstrahlen aus einer Referenz-Braggzelle, die von einem Referenz-Hochfrequenzsignal ansteuerbar ist, das ein aus einer Vielzahl von Referenzfrequenzen enthaltendes Referenzfrequenzspektrum aufweist. Die Referenz-Braggzelle erzeugt aus einem zugeleiteten Lichtstrahl je Frequenz des Referenzspektrums einen abgelenkten Lichtstrahl verschobener Frequenz, wobei verschiedene Frequenzen des Referenzfrequenzspektrums verschieden abgelenkte und verschiedene frequenzverschobene Referenzlichtstrahlen erzeugen. Diese Referenzlichtstrahlen werden in einem Strahlteiler mit von der Signal-Braggzelle abgelenktem Licht kombiniert und auf nebeneinander angeordnete Detektorfenster von Heterodyndetektoren fokussiert. Dabei sollte das Licht eines Referenzstrahls nur auf das Detektorfenster des zugeordneten Detektors und nicht auf die Fenster anderer Detektoren gelangen. Bedingt durch die begrenzte Auflösung der Braggzelle und durch Streulicht gelangt jedoch Licht jedes Referenzstrahls nicht nur auf das zugeordnete Detektorfenster, auf das er fokussiert ist, sondern auch auf benachbarte Detektorfenster. In jedem Detektorfenster entsteht auf diese Weise ein Störuntergrund, der ein Frequenzgemisch beinhaltet, das sowohl mit sich selbst Scheinsignale erzeugt, als auch mit Licht von der Signal-Braggzelle her Detektionssignale vortäuscht. Zur Vermeidung des Störuntergrunds müßten die Referenzstrahlen räumlich auf die Detektorfenster begrenzt werden. Eine diese Beschränkung bewirkende optisch ideale Lichtverteilung in den Referenzstrahlen läßt sich praktisch nicht realisieren.

Aufgabe der Erfindung ist es, einen interferometrischen Braggzellen-Spektralanalysator der eingangs genannten Art zu schaffen, bei dem der Störuntergrund dennoch vollständig vermieden werden kann.

Diese Aufgabe wird durch die im kennzeichnenden Teil des Patentanspruchs 1 angegebenen Merkmale gelöst. Eine bevorzugte Realisierung des erfindungsgemäßen Spektralanalysators geht aus dem Anspruch 2 hervor.

Aus den Ansprüchen 3 bis 9 gehen bevorzugte Ausgestaltungen des Analysators nach Anspruch 3 hervor.

Aus den Ansprüchen 10 und 11 gehen ein Modulatorbaustein bzw. ein Modulator-Koppler-Baustein hervor, die insbesondere für bestimmte Ausführungsformen des erfindungsgemäßen Modulators geeignet sind.

Die Erfindung wird anhand der Figuren in der folgenden Beschreibung beispielhaft näher erläutert. Von den Figuren zeigen:

Figur 1 den schematischen Aufbau einer beispielshaften Ausführungsform des erfindungsgemäßen Analysators,

Figur 2 die Ansicht eines Modulator-Koppler-Bausteins für den erfindungsgemäßen Analysator,

Figur 3 einen Modulatorbaustein, mit dem mehrere Referenzstrahlen gleicher verschobener Frequenz erzeugt werden können, und der für eine Ausführungsform eines erfindungsgemäßen Analysators mit reduzierter Modulatorzahl geeignet ist, und

Figur 4 in schematischer Darstellung eine Anordnung aus einer Vielzahl von Modulator-Koppler-Bausteinen mit zugeordneten selektiven Wandlern, die von einer gemeinsamen Deltaimpulsfolge parallel ansteuerbar sind.

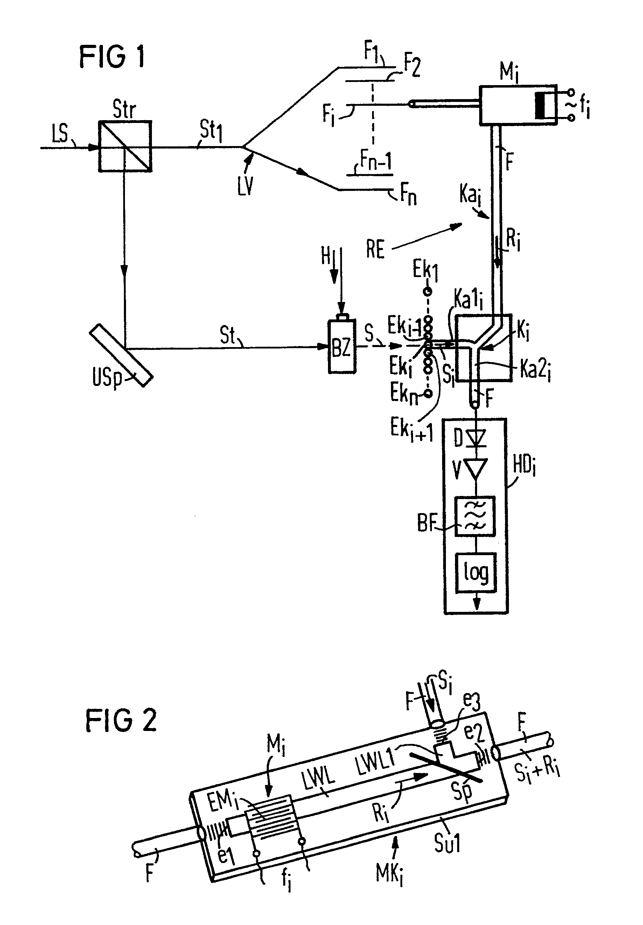

Der in Figur 1 dargestellte interferometrische Spektralanalysator besteht im wesentlichen aus der von einem zu analysierenden Hochfrequenzsignal H ansteuerbaren Signal-Braggzelle BZ, die aus einem zugeleiteten Lichtstrahl St in Abhängigkeit vom Hochfrequenzsignal H Licht S ablenkt, aus der Einrichtung RE zum Erzeugen von mehreren gegeneinander frequenzverschobenen Referenzlichtstrahlen $R_i$ und aus mehreren optoelektrischen Heterodyndetektoren $HD_i$.

Der Index i bedeutet im folgenden stets eine Zahl von 1 bis n, z.B. n = 100, und die mit diesem Index i bezeichneten Teile in den Figuren sind stets n-mal vorhanden, soweit nichts anderes gesagt ist.

Jeder Referenzstrahl $R_i$ wird mit von der Braggzelle BZ abgelenktem Licht S überlagert einem zugeordneten Heterodyndetektor $HD_i$ zur Heterodyndetektion zugeleitet.

Wie bei herkömmlichen interferometrischen Braggzellen-Spektralanalysatoren wird ein Laserstrahl LS durch einen Strahlteiler Str in zwei Teilstrahlen St und $St_1$ zerlegt, von

denen der eine Teilstrahl St, beispielsweise über einen Umlenkspiegel USp, der Signal-Braggzelle BZ zugeführt wird, und wobei aus dem anderen Teilstrahl $St_1$ die frequenzverschobenen Referenzlichtstrahlen $R_i$ abgeleitet werden. Wie schon erwähnt, werden bei herkömmlichen interferometrischen Braggzellen-Spektralanalysatoren diese Referenzlichtstrahlen $R_i$ durch eine im Strahlengang des Teilstrahls $St_1$ angeordnete Referenz-Braggzelle erzeugt. Obwohl die von dieser Referenz-Braggzelle erzeugten Referenz-Braggzelle erzeugten Referenzlichtstrahlen auf getrennte Punkte fokussiert werden, bleiben sie doch bis zu einem gewissen Grad überlagert, wodurch der erwähnte Störhintergrund entsteht, der nicht beseitigt werden kann.

Dieser Störhintergrund kann bei dem hier beschriebenen Analysator beseitigt werden. Dazu ist anstelle einer Referenz-Braggzelle die Einrichtung RE zum voneinander getrennten Erzeugen der frequenzverschobenen Referenzlichtstrahlen $R_i$ und getrennten Überlagern dieser Referenzlichtstrahlen mit von der Braggzelle BZ abgelenktem Licht S vorgesehen. Dabei ist prinzipiell jede diese Funktion erfüllende Einrichtung RE verwendbar.

Eine bevorzugte Ausführungsform einer solchen Einrichtung RE weist gemäß Figur 1 mehrere jeweils von einer Referenz-Modulationsfrequenz $f_i$ ansteuerbare Modulatoren $M_i$ zum Verschieben einer Lichtfrequenz auf, wobei verschiedene Modulatoren $M_i$ verschiedene Referenzlichtstrahlen $R_i$ verschiedene Verschiebungen der Lichtfrequenz erzeugen.

Für n zu erzeugende Referenzlichtstrahlen $R_i$ mit gegeneinander verschobenen Lichtfrequenzen sind n Modulatoren $M_i$ vorzusehen, denen die zu verschiebende Lichtfrequenz zuzuführen ist.

Die Zuführung der zu verschiebenden Lichtfrequenz kann über n getrennte lichtführende Kanäle $F_i$ erfolgen, die beispielsweise aus Lichtleitfasern bestehen können. An jedem Kanal $F_i$ ist ein zugeordneter Modulator $M_i$ angeschlossen. Die zu verschiebende Lichtfrequenz kann in die Kanäle $F_i$ beispielsweise durch einen Lichtleistungsverteiler LV eingespeist werden. Jeder vorzugsweise akustooptische oder elektrooptische Modulator $M_i$ verschiebt die Frequenz des zugeführten Laserlichts mit hohem Wirkungsgrad entsprechend einer extern angelegten, hochfrequenten Modulationsfrequenz $f_i$, die beispielsweise bei 2 GHz liegen kann.

Der von einem Modulator $M_i$ erzeugte Referenzlichtstrahl $R_i$ wird getrennt von den anderen Referenzlichtstrahlen dem zugeordneten Heterodyndetektor $HD_i$ zugeführt, vorzugsweise in einer Lichtleitfaser F.

Die Überlagerung der Referenzlichtstrahlen $R_i$ mit von der Braggzelle BZ abgelenktem Licht S erfolgt vorzugsweise so, daß dieses abgelenkte Licht S nebeneinander angeordneten Einkoppelenden $Ek_i$ mehrerer anderer lichtführender Kanäle $Kal_i$, beispielsweise Lichtleitfasern F, zugeleitet ist, wobei jeder andere Kanal $Kal_i$ mit einem zugeordneten, getrennt geführten Referenzlichtstrahl $R_i$ durch einen zugeordneten Koppler $K_i$ verbunden ist. In diesem Koppler $K_i$ wird der in diesem Kanal $Ka_i$ geführte Referenzlichtstrahl $R_i$ mit einem in diesem anderen Kanal $Kal_i$ zugeführten und von der Braggzelle BZ abgelenkten Licht S stammenden Licht $S_i$ überlagert. Das entstandene überlagerte Licht $S_i + R_i$ wird in einem gemeinsamen lichtführenden Kanal, beispielsweise einem Abschnitt $Ka2_i$ des Kanals $Ka_i$ getrennt von anderem Licht dem zugeordneten Heterodyndetektor $HD_i$ zugeführt.

Auf diese Weise wird ein Störuntergrund völlig vermieden.

Zweckmäßigerweise wird jeder Modulator $M_i$ und jeder zugeordnete Koppler $K_i$ in einem Modulator-Koppler-Baustein $MK_i$ baulich vereinigt.

Eine sich durch ihre Kompaktheit auszeichnende Ausführungsform eines derartigen Bausteins $MK_i$, der nicht nur für einen hier beschriebenen Analysator anwendbar ist, geht aus der Figur 2 hervor. Bei diesem Baustein ist auf einem Substrat Sul aus akusto- oder elektrooptischem Material ein streifenförmiger Wellenleiter LWL integriert, an dessen Enden $e_1$, $e_2$ Lichtleitfasern F ankoppelbar ist. Auf dem Lichtwellenleiter LWL ist der Modulator $M_i$ in Form eines von der zugeordneten Modulationsfrequenz $f_i$ ansteuerbaren Elektrodenmusters $EM_i$ ausgebildet. Der Koppler $K_i$ ist in Form einer schräg im Wellenleiter LWL angeordneten teildurchlässigen Spiegelschicht Sp ausgebildet, zu der ein weiterer im Substrat Sul integrierter Wellenleiter LWL1 führt, an dessen von der Spiegelschicht Sp fernes Ende $e_3$ eine Lichtleitfaser F ankoppelbar ist. Die Kopplung einer Faser an einen streifenförmigen Lichtwellenleiter kann über bekannte Koppeleinrichtungen erfolgen. Über den Eingang $e_1$ wird Laserlicht der zu verschiebenden Lichtfrequenz in den Lichtwellenleiter LWL eingekoppelt. Der Modulator $M_i$ verschiebt die Frequenzen dieses Lichts und es entsteht der im Wellenleiter LWL geführte Referenzlichtstrahl $R_i$, der zu einem Teil durch die teildurchlässige Spiegelschicht Sp hindurchgeht. Über das Ende $e_3$ des weiteren Wellenleiters LWL1 wird der Lichtanteil $S_i$

der teildurchlässigen Spiegelschicht Sp zugeführt, das zum Teil umgelenkt und in den Lichtwellenleiter LWL eingekoppelt wird. Das überlagerte Licht $S_i + R_i$ ist dem Ausgang $e_2$ des Lichtwellenleiters LWL entnehmbar. Es können auch Modulator-Koppler-Bausteine verwendet werden, bei denen auf einem Substrat mehrere Modulatoren zur Erzeugung verschiedener Referenzlichtstrahlen und mehrere zugeordnete Koppler integriert sind.

Bei dem beschriebenen Analysator ist für jeden zu erzeugenden Referenzlichtstrahl $R_i$ je ein Modulator $M_i$, je ein Koppler $K_i$ und je ein Hochfrequenzoszillator zur Erzeugung der Modulationsfrequenz $f_i$ erforderlich. Bei n = 100 zu erzeugenden Referenzlichtstrahlen bedeutet dies, daß auch 100 Modulatoren, Koppler und Oszillatoren benötigt werden.

Diese Komplexität läßt sich durch zwei Maßnahmen verringern.

Einmal erzeugt die Einrichtung RE zum voneinander getrennten Erzeugen der Referenzlichtstrahlen mehrere Referenzlichtstrahlen gleicher Lichtfrequenz, die verschiedenen Heterodyndetektoren für voneinander verschiedene Zwischenfrequenzen zuleitbar sind. Beispielsweise kann man für k aufeinanderfolgende Referenzlichtstrahlen k unterschiedliche Zwischenfrequenzen zulassen, die k Heterodyndetektoren für diese unterschiedlichen Zwischenfrequenzen zugeleitet sind. In diesem Fall müssen anstelle von n nur n/k verschiedene Frequenzverschiebungen vorgenommen werden. Man benötigt daher prinzipiell nur n/k verschiedene Modulatoren $M_i$ und Hochfrequenzoszillatoren zur Frequenzverschiebung, da von jedem Modulator k Referenzlichtstrahlen gleicher Frequenz erzeugt werden können. Läßt man beispielsweise für aufeinanderfolge Referenzlichtstrahlen die unterschiedlichen Zwischenfrequenzen 40, 50, 60 und 70 MHz zu, so kann ein Modulator vier Referenzlichtstrahlen gleichzeitig erzeugen. In diesem Fall kann die Zahl der nötigen Modulatoren und Oszillatoren von beispielsweise n = 100 auf 25 verringert werden. Wichtig ist dabei allerdings, daß die Bandpaßfilter der zugeordneten Heterodyndetektoren auf die zugeordneten Zwischenfrequenzen 40, 50, 60 und 70 MHz ausgelegt sind.

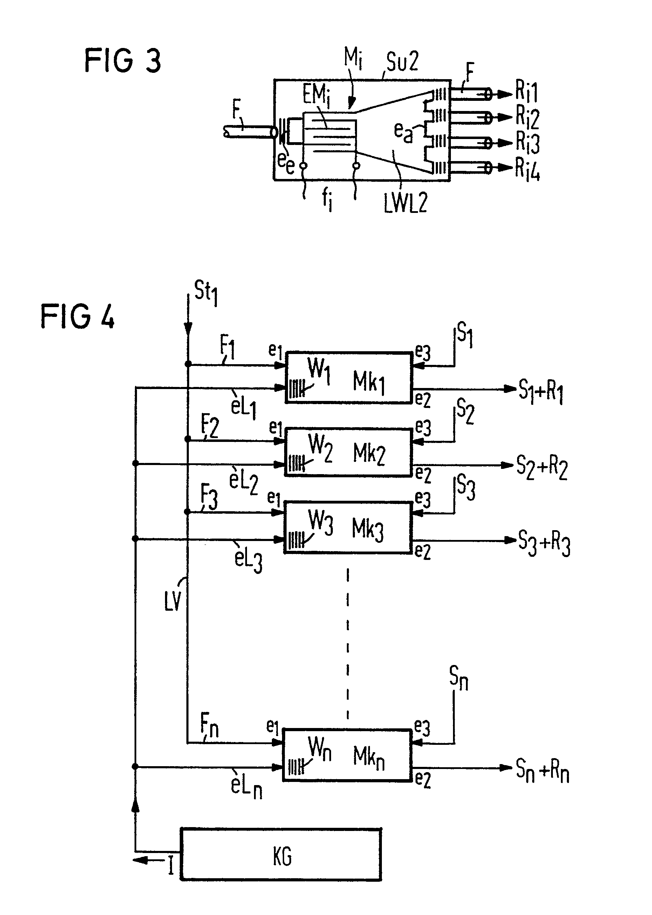

Ein Modulator-Baustein zum Erzeugen mehrerer getrennter Lichtstrahlen ist in der Figur 3 dargestellt, dessen Anwendung nicht auf einen Braggzellen-Analysator beschränkt ist. Bei diesem Modulator-Baustein ist auf einem Substrat Su2 aus akusto- oder elektrooptischem Material ein an einem Ende $e_a$ konisch erweiterter streifenförmiger Lichtwellenleiter LWL2 ausgebildet, auf dem in der Nähe seines anderen Endes $e_e$ der Modulator $M_i$ in Form eines von einer Modulationsfrequenz $f_i$ ansteuerbaren Elektrodenmuster $EM_i$ ausgebildet ist. An das verbreiterte Enden $e_a$ sind mehrere getrennt fortführende Lichtleitfasern F und an das andere Ende $e_e$ eine zuführende Lichtleitfaser F ankoppelbar. Das über das andere Ende $e_e$ eingekoppelte Laserlicht wird durch den Modulator $M_i$ frequenzverschoben und in einem entsprechend gefertigten Teil des Lichtwellenleiters LWL2 auf die fortführenden Fasern F verteilt. Die Ankopplung der Fasern an den Streifenwellenleiter kann durch bekannte Koppeleinrichtungen erfolgen.

Die Anzahl der benötigten Hochfrequenz-Oszillatoren kann reduziert werden, indem jedem benötigten Modulator $M_i$ oder Modulator-Baustein $MK_i$ je ein selektiver Wandler $W_i$ zugeordnet ist, von denen jeder aus einer zugeführten und allen Wandlern $W_i$ gemeinsamen Deltaimpulsfolge I, die dem betreffenden Modulator $M_i$ zugeordnete Modulationsfrequenz $f_i$ ausgewählt und dem betreffenden Modulator $M_i$ zuführt.

In der Figur 4 ist eine aus n Modulator-Koppler-Bausteinen $MK_i$ (i = 1, 2, 3, ..., n) gebildete entsprechende Anordnung dargestellt, wobei auf jedem Baustein $MK_i$ ein zugeordneter Wandler $W_i$ integriert ist. Das Laserlicht aus dem Teilstrahl $St_1$ wird über den Leistungsverteiler LV und die Fasern $F_i$ den Eingängen $e_1$ der Bausteine $MK_i$ zugeführt. Die beispielsweise von einem Kammgenerator KG erzeugte Deltaimpulsfogle I wird den Wandlern $W_i$ der verschiedenen Modulator-Koppler-Bausteine $MK_i$ parallel über elektrische Leitungen $eL_i$ zugeführt. Den Eingängen $e_3$ der Bausteine $MK_i$ wird das zugeordnete abgelenkte Licht $S_i$ zugeführt und aus den Ausgängen $e_2$ der Bausteine $MK_i$ wird das betreffende überlagerte Licht $S_i + R_i$ entnommen.

Bei der Anordnung nach Figur 4 wird nur ein Hochfrequenzoszillator benötigt, beispielsweise ein den Kammgenerator KG ansteuernder Quarzoszillator.

Es sei darauf hingewiesen, daß integriert optische Modulatoren bei hohen Frequenzen bereits angeboten werden und Koppler ebenfalls hergestellt werden bzw. beschrieben sind. Selektive akustische Wandler lassen sich in der bekannten SAW-Technik herstellen.

**Patentansprüche**

1. Interferometrischer Braggzellen-Spektralanalysator mit einer von einem zu analysierenden Hochfrequenzsignal (H) ansteuerbaren Signal-Braggzelle (BZ), die aus einem zugeleiteten Lichtstrahl (St) in Abhängigkeit vom Hochfrequenzsignal (H) Licht (S) ablenkt, einer Einrichtung (RE) zum Erzeugen von mehreren gegeneinander frequenzverschobenen Referenzlichtstrahlen (R$_i$) und mit mehreren optoelektrischen Heterodyndetektoren (HD$_i$),wobei jeder Referenzlichtstrahl (R$_i$) mit von der Braggzelle (BZ) abgelenktem Licht überlagert einem Heterodyndetektor (HD$_i$) zur Heterodyndetektion zuleitbar ist,
**gekennzeichnet durch**
eine Einrichtung (RE) zum voneinander getrennten Erzeugen von Referenzlichtstrahlen (R$_i$) und getrennten Überlagern der Referenzlichtstrahlen (R$_i$) mit von der Braggzelle (BZ) abgelenktem Licht (S).

2. Analysator nach Anspruch 1, **dadurch gekennzeichnet,** daß die Einrichtung (RE) zum voneinander getrennten Erzeugen und Überlagern der Referenzlichtstrahlen (R$_i$) mehrere jeweils von einer Referenz-Modulationsfrequenz (f$_i$) ansteuerbare Modulatoren (M$_i$) zum Verschieben einer Lichtfrequenz aufweist, wobei verschiedene Modulatoren (M$_i$) verschiedene Referenzlichtstrahlen (R$_i$) verschiedene Verschiebungen der Lichtfrequenzen erzeugen.

3. Analysator nach Anspruch 2, **dadurch gekennzeichnet,** daß die Einrichtung (RE) zum voneinander getrennten Erzeugen der Referenzlichtstrahlen (R$_i$) mehrere Referenzlichtstrahlen (R$_{i1}$ bis R$_{i4}$) gleicher Lichtfrequenz erzeugt, die verschiedenen Heterodyndetektoren für voneinander verschiedene Zwischenfrequenzen zuleitbar sind.

4. Analysator nach einem der vorhergehenden Ansprüche, **dadurch gekennzeichnet,** daß die Referenzlichtstrahlen (R$_i$) in verschiedenen lichtführenden Kanälen (Ka$_i$) geführt sind.

5. Analysator nach einem der vorhergehenden Ansprüche, **dadurch gekennzeichnet,** daß das von der Braggzelle (BZ) abgelenkte Licht (S) nebeneinander angeordneten Einkoppelenden (Ek$_1$, ..., Ek$_1$, ..., Ek$_n$) mehrerer anderer lichtführender Kanäle (Kal$_i$) zugeleitet ist, wobei jeder andere Kanal (Kal$_i$) mit einem zugeordneten Kanal (Ka$_i$) zum Führen eines Referenzlichtstrahls (R$_i$) durch einen Koppler (K$_i$) verbunden ist, in dem der in diesem Kanal (K$_i$) geführte Referenzlichtstrahl (R$_i$) mit einem in diesem anderen Kanal (Kal$_i$) zugeführten und von dem von der Braggzelle (BZ) abgelenkten Licht (S) stammenden Licht (S$_i$) überlagert ist.

6. Analysator nach Anspruch 5, **dadurch gekennzeichnet,** daß das in einem Koppler (K$_i$) gebildete überlagerte Licht (S$_i$ + R$_i$) in einem gemeinsamen lichtführenden Kanal (Ka2) einem zugeordneten Heterdyndetektor (HD$_i$) zugeleitet ist.

7. Analysator nach Anspruch 5 oder 6, **dadurch gekennzeichnet,** daß jeder Modulator (M$_i$) und ein zugeordneter Koppler (K$_i$) in einem Modulator-Koppler-Baustein (MK$_i$) baulich vereinigt sind.

8. Analysator nach einem der Ansprüche 4 bis 6, **dadurch gekennzeichnet,** daß ein lichtführender Kanal (Ka$_i$, Kal$_i$) eine Lichtleitfaser (F) aufweist.

9. Analysator nach einem der Ansprüche 3 bis 8, **dadurch gekennnzeichnet,** daß jedem Modulator (M$_i$) je ein selektiver Wandler (W$_i$) zugeordnet ist, von denen jeder aus einer zugeführten und allen Wandlern (W$_i$) gemeinsamen Deltaimpulsfolge, die dem betreffenden Modulator (M$_i$) zugeordnete Modulationsfrequenz (f$_i$) auswählt und dem betreffenden Modulator (M$_i$) zuführt.

10. Modulator-Baustein zum Erzeugen mehrerer getrennter Lichtstrahlen (R$_{i1}$ bis R$_{i4}$) gleicher Lichtfrequenz, insbesondere für einen Analysator nach Anspruch 3, **dadurch gekennzeichnet,** daß auf einem Substrat (Su2) aus akusto- oder elektrooptischem Material ein an einem Ende (e$_a$) konisch erweiterter, streifenförmiger Lichtwellenleiter (LWL2) ausgebildet ist, auf dem in der Nähe seines anderen Endes (e$_e$) der Modulator (M$_i$) in Form eines von einer Modulationsfrequenz (f$_i$) ansteuerbaren Elektrodenmusters (EM$_i$) ausgebildet ist, wobei an das verbreiterte Ende (e$_a$) mehrere getrennte fortführende Lichtleitfasern (F) und an das andere Ende (e$_e$) eine zuführende Lichtleitfaser (F) ankoppelbar ist.

11. Modulator-Koppler-Baustein, insbesondere für einen Analysator nach Anspruch 7, **dadurch gekennzeichnet,** daß auf einem Substrat (Sul) aus akusto- oder elektrooptischem Material ein streifenförmiger Wellenleiter (LWL) integriert ist, an dessen Enden (e$_1$, e$_2$) Lichtleitfasern (F) ankoppelbar sind, auf dem der Modulator (M$_i$) in Form eines von der zugeordneten Modulationsfrequenz (f$_i$) ansteuerbaren Elektrodenmusters (EM$_i$) ausgebildet ist und in dem der Koppler (K$_i$) in Form einer schräg im Wellenleiter (LWL) angeordneten teildurchlässigen Spiegelschicht (Sp) ausgebildet ist, zu der ein weiterer im Substrat (Sul) integrierter Wellenleiter (LWL1) führt, an dessen von der Spiegelschicht (Sp) fernes Ende (e₃) eine Lichtleitfasern (F) ankoppelbar ist.

# FIG 1

# FIG 2

# FIG 3

# FIG 4

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| A | IEE PROCEEDINGS SECTION A à I, Band 113, Nr. 1, Teil J, Februar 1986, Seiten 26-30, Stevenage, Herts, GB; J. MELLIS et al.: "High-dynamic-range interferometric Bragg-cell spectrum analyser" * Seiten 27-28 * | 1 | G 01 R 23/17 G 02 F 1/11 |
| A | US-A-4 725 774 (R.L. DAVIS et al.) * Spalten 2-4 * | 1,10,11 | |
| A | DE-A-3 203 679 (LICENTIA P.V. GmbH) * Seiten 8-9; Figur 1 * | 1,10,11 | |
| A | PATENT ABSTRACTS OF JAPAN, Band 10, Nr. 308 (P-508)[2364], 21. Oktober 1986; & JP-A-61 122 576 (MITSUBISHI ELECTRIC CORP.) 10-06-1986 * Zusammenfassung * | 1,10,11 | |
| A | GB-A-2 119 510 (THE MARCONI CO.) * Seite 2, Figuren 2-3 * | 1,10,11 | RECHERCHIERTE SACHGEBIETE (Int. Cl.5) G 01 R 23/17 G 02 F 2/00 G 02 F 1/11 |

Der vorliegende Recherchenbericht wurde für alle Patentansprüche erstellt

| Recherchenort | Abschlußdatum der Recherche | Prüfer |
|---|---|---|
| DEN HAAG | 05-10-1990 | BOEHM CH.E.D. |